# EUROPÄISCHE PATENTANMELDUNG

(11) **EP 4 517 689 A1**
(43) Veröffentlichungstag der Anmeldung: **05.03.2025**
(21) Anmeldenummer: 23194565.0
(22) Anmeldetag: 31.08.2023
(51) Int. Cl.: G06V 10/774, G06V 10/82, G06V 20/56, G06V 20/58

(54) **VERHALTEN EINES AUTONOMEN WAHRNEHMUNGSBASIERTEN SYSTEMS**

(71) Anmelder: Robert Bosch GmbH, 70442 Stuttgart (DE)
(72) Erfinder: Woehrle, Matthias, 74321 Bietigheim-Bissingen (DE); Stellet, Jan, 70469 Stuttgart (DE)

(57) **Zusammenfassung**

Ein erster Aspekt der vorliegenden Offenbarung betrifft ein computer-implementiertes Verfahren zum Trainieren eines Maschinenlernmodells zur Bewertung eines Verhaltens eines autonomen Systems, dafür konfiguriert eine Wahrnehmungsaufgabe zu lösen, umfassend Empfangen von Sensordaten durch ein Wahrnehmungssystem des autonomen Systems; Empfangen von Metadaten, wobei die Metadaten einen Einfluss auf eine Lösbarkeit der Wahrnehmungsaufgabe codieren; Ermitteln einer Fehlerwahrscheinlichkeit basierend auf den empfangenen Sensordaten; Bereitstellen des Maschinenlernmodells, dafür ausgelegt, Sensordaten und Metadaten auf eine Fehlerwahrscheinlichkeit für die Lösung der Wahrnehmungsaufgabe abzubilden; und Trainieren des Maschinenlernmodells auf Basis eines Trainingsdatensatzelements umfassend die empfangenen Sensordaten, die empfangenen Metadaten und die ermittelte Fehlerwahrscheinlichkeit. Ein zweiter Aspekt der vorliegenden Offenbarung betrifft ein computer-implementiertes Verfahren zur Bewertung eines Verhaltens eines autonomen Systems, dafür konfiguriert eine Wahrnehmungsaufgabe zu lösen.

## Beschreibung

### Stand der Technik

Autonome Systeme, die auf mindestens einer Wahrnehmungsaufgabe basieren, können zum Beispiel ganz oder teilweise selbstfahrende Fahrzeuge und/oder Roboter sein. Die zu lösende mindestens eine Wahrnehmungsaufgabe kann zum Beispiel eine Objekterkennung umfassen. Alternativ oder zusätzlich kann die zu lösende mindestens eine Wahrnehmungsaufgabe zum Beispiel eine semantische Segmentierung und/oder eine Freiraumerkennung umfassen. Die durch das Wahrnehmungssystem des autonomen Systems empfangenen Sensordaten können zum Beispiel Bilddaten (Video) umfassen. Alternativ oder zusätzlich können die durch das Wahrnehmungssystem des autonomen Systems empfangenen Sensordaten Radar-, LiDAR-, Ultraschall-, Bewegungs-, Akustik- und/oder thermische Daten umfassen.

Im Hinblick auf das Ziel, verlässliche und sichere autonome Systeme bereitzustellen, ist es wünschenswert das Verhalten der autonomen Systeme bereits zu Entwicklungszeiten bestmöglich bewerten zu können. Da autonome Systeme gerade auch im offenen Kontext eingesetzt werden sollen, stellen solche Bewertungen aber weiterhin eine große Herausforderung dar. Neben Testläufen (von Prototypen oder aus vorhergehenden Entwicklungsprojekten) werden zunehmend Simulationen zur Lösung dieses Problems eingesetzt.

### Offenbarung der Erfindung

Ein erster allgemeiner Aspekt der vorliegenden Offenbarung betrifft ein computer-implementiertes Verfahren zum Trainieren eines Maschinenlernmodells zur Bewertung eines Verhaltens eines autonomen Systems, das dafür konfiguriert ist, eine Wahrnehmungsaufgabe, z.B. umfassend eine Objekterkennung, zu lösen - insbesondere zur (der Bewertung des Verhaltens des autonomen Systems vorgelagerten) Ermittlung einer Fehlerwahrscheinlichkeit für die Lösung der Wahrnehmungsaufgabe, z.B. für die Objekterkennung.

Das Verfahren umfasst Empfangen von Sensordaten durch ein (z.B. simulatives oder reelles) Wahrnehmungssystem des autonomen Systems.

Das Verfahren umfasst weiterhin Empfangen von Metadaten, wobei die Metadaten einen Einfluss auf eine Lösbarkeit der Wahrnehmungsaufgabe, z.B. auf eine Erkennbarkeit des Objekts codieren.

Das Verfahren umfasst weiterhin Ermitteln einer Fehlerwahrscheinlichkeit für die Lösung der Wahrnehmungsaufgabe, z.B. für die Objekterkennung, basierend auf den empfangenen Sensordaten.

Das Verfahren umfasst weiterhin Bereitstellen des Maschinenlernmodells, das dafür ausgelegt ist, (zumindest) Sensordaten und Metadaten auf (zumindest) eine Fehlerwahrscheinlichkeit für die Lösung der Wahrnehmungsaufgabe, z.B. für die Objekterkennung abzubilden.

Das Verfahren umfasst weiterhin Trainieren des Maschinenlernmodells auf Basis eines Trainingsdatensatzelements umfassend die empfangenen Sensordaten, die empfangenen Metadaten und die ermittelte Fehlerwahrscheinlichkeit.

Ein zweiter allgemeiner Aspekt der vorliegenden Offenbarung betrifft ein computer-implementiertes Verfahren zur Bewertung eines Verhaltens eines autonomen Systems, das dafür konfiguriert ist, eine Wahrnehmungsaufgabe, z.B. umfassend eine Objekterkennung, zu lösen.

Das Verfahren umfasst Simulieren eines Wahrnehmungssystems des autonomen Systems.

Das Verfahren umfasst Simulieren einer Umgebung des Wahrnehmungssystems. Das Verfahren umfasst Bereitstellen eines Maschinenlernmodells, das darauf ausgelegt und trainiert ist, (zumindest) Sensordaten und Metadaten (zumindest) auf eine Fehlerwahrscheinlichkeit für die Lösung der Wahrnehmungsaufgabe, z.B. für die Objekterkennung abzubilden, wobei die Metadaten einen Einfluss auf eine Lösbarkeit der Wahrnehmungsaufgabe, z.B. auf eine Erkennbarkeit des Objekts codieren.

Das Verfahren umfasst weiterhin Empfangen von Sensordaten und Metadaten. Das Verfahren umfasst weiterhin Anwenden des Maschinenlernmodells auf den empfangenen Sensordaten und Metadaten, wobei eine Fehlerwahrscheinlichkeit ermittelt wird.

Das Verfahren umfasst weiterhin Bewerten des Verhaltens des autonomen Systems basierend auf der Fehlerwahrscheinlichkeit, wobei eine Bewertung resultiert.

Ein dritter allgemeiner Aspekt der vorliegenden Offenbarung betrifft ein Computer-System, das dafür ausgelegt ist, das computer-implementierte Verfahren - nach dem ersten allgemeinen Aspekt (oder einer Ausführungsform) davon - zum Trainieren eines Maschinenlernmodells zur Bewertung eines Verhaltens eines autonomen Systems, das dafür konfiguriert ist, eine Wahrnehmungsaufgabe, z.B. umfassend eine Objekterkennung, zu lösen, und/oder das computer-implementierte Verfahren - nach dem zweiten allgemeinen Aspekt (oder einer Ausführungsform) davon - zur Bewertung eines Verhaltens eines autonomen Systems, das dafür konfiguriert ist, eine Wahrnehmungsaufgabe, z.B. umfassend eine Objekterkennung, zu lösen, auszuführen.

Ein vierter allgemeiner Aspekt der vorliegenden Offenbarung betrifft ein Computer-Programm, das dafür ausgelegt ist, das computer-implementierte Verfahren - nach dem ersten allgemeinen Aspekt (oder einer Ausführungsform davon) - zum Trainieren eines Maschinenlernmodells zur Bewertung eines Verhaltens eines autonomen Systems, das dafür konfiguriert ist, eine Wahrnehmungsaufgabe, z.B. umfassend eine Objekterkennung, zu lösen, und/oder das computer-implementierte Verfahren - nach dem zweiten allgemeinen Aspekt (oder einer Ausführungsform davon) - zur Bewertung eines Verhaltens eines autonomen Systems, das dafür konfiguriert ist, eine Wahrnehmungsaufgabe, z.B. umfassend eine Objekterkennung, zu lösen, auszuführen.

Ein fünfter allgemeiner Aspekt der vorliegenden Offenbarung betrifft ein computer-lesbares Medium oder Signal, das das Computer-Programm nach dem vierten allgemeinen Aspekt speichert und/oder enthält.

Die in dieser Offenbarung vorgeschlagenen Verfahren nach dem ersten oder zweiten allgemeinen Aspekt (oder einer Ausführungsform davon) sind darauf gerichtet, das Verhalten des autonomen Systems insbesondere bereits zur Entwicklungszeit besser bewerten zu können. Insbesondere dienen sie dazu die Auswirkung von Fehlern in der Wahrnehmung auf eine autonome (Fahr-)funktion zu evaluieren. Gegebenenfalls und in Abhängigkeit davon, kann das autonome System insbesondere bereits zur Entwicklungszeit verbessert werden.

Die in dieser Offenbarung vorgeschlagenen Verfahren zielen insbesondere darauf ab Fehlermodelle für ein einzelnes Wahrnehmungssystem des autonomen Systems bereitzustellen. Hierzu wird ausgehend zumindest von Sensordaten und Metadaten jeweils eine Fehlerwahrscheinlichkeit berechnet. Die Metadaten umfassen z.B. einen Verdeckungsgrad eines zu erkennenden Objekts, einen Helligkeitswert und/oder einen Entfernungswert des zu erkennenden Objekts und codieren somit einen Einfluss auf eine Lösbarkeit der Wahrnehmungsaufgabe, z.B. auf eine Erkennbarkeit des Objekts. Insbesondere hängt somit die Fehlerwahrscheinlichkeit nicht nur von den Metadaten, sondern auch von den Sensordaten ab. Dadurch können Szenarien, die durch das Wahrnehmungssystem aufgenommen werden, besser aufgelöst und bewertet werden.

Im Falle einer Objekterkennung kann es beispielsweise darum gehen, einen Fußgänger zu erkennen. Eine solche Erkennung wird in der Regel durch einen hohen Verdeckungsgrad erschwert. Dennoch kann der Fußgänger unter Umständen dann richtig erkannt werden, wenn charakteristische Teile des Fußgängers (z.B. ein Arm und/oder eine Hand) trotz des hohen Verdeckungsgrades für das Wahrnehmungssystem noch sichtbar sind. In diesem Fall muss nicht allein aufgrund des hohen Verdeckungsgrades eine hohe Fehlerwahrscheinlichkeit ausgegeben werden (wie es der Fall wäre, wenn die Fehlerwahrscheinlichkeit nur von den Metadaten abhinge), sondern kann die Fehlerwahrscheinlichkeit dank der noch genügend gut zu erkennenden charakteristischen Teile des Fußgängers geringer ausfallen. Somit kann die Schwierigkeit, die vorgegebene Wahrnehmungsaufgabe zu lösen, besser quantifiziert werden. Dadurch können vor allem dann hohe Fehlerwahrscheinlichkeiten ausgegeben werden, wenn echte Probleme bei der Lösbarkeit der Wahrnehmungsaufgabe bestehen. Dadurch können echte Problemfälle bei der Lösung der Wahrnehmungsaufgabe schneller und besser identifiziert werden, das autonome System sodann gezielt verbessert werden (z.B. durch Hinzunahme weiterer Sensoren mit anderen Blickwinkeln, andere Sensorarten, Hinzunahme von Sensordaten von unmittelbar früheren Zeitpunkten etc.). Anderenfalls können (unnötige) Anpassungen des autonomen Systems veranlasst durch unechte Probleme, in denen die Wahrnehmungsaufgabe doch noch zufriedenstellend gelöst werden konnte, vermieden werden.

Das in dieser Offenbarung vorgeschlagene Verfahren nach dem zweiten allgemeinen Aspekt (oder einer Ausführungsform davon) ermöglicht eine closed-loop Simulation umfassend eine Simulation des autonomen Systems einschließlich dessen Wahrnehmungssystems und eine Simulation der Umgebung des Wahrnehmungssystems z.B. umfassend das zu erkennende Objekt. Zum Beispiel kann eine solche closed-loop Simulation aufzeigen, welche noch ungelabelten Szenarien (auch: Sequenzen) große Auswirkungen auf das Gesamtsystem haben. Damit können aus einer großen Anzahl von Sensordaten die für das Systemverhalten relevanten Sensordaten selektiert und z.B. gelabelt werden. Zudem kann wie oben bereits beschrieben das autonome System verbessert werden.

Ein Ziel der closed-loop Simulation kann darin gesehen werden, den Effekt von Fehlern des Wahrnehmungssystems auf das Gesamtsystem-Verhalten zu bestimmen. Dabei sollte aber das Wahrnehmungssystem sich nicht auf Fehler einer konkreten Implementierung eines Algorithmus zur Lösung der Wahrnehmungsaufgabe fokussieren, sondern auf Fehler, die aufgrund der konkreten Aufgabe und wahrzunehmenden Umgebung und zugehörigen Sensordaten entstehen. In einer Ausführungsform des Verfahrens nach dem zweiten Aspekt kann das zum Beispiel insbesondere dadurch erreicht werden, dass eine Vielzahl weiterer Maschinenlernmodellen, jedes dafür ausgelegt und trainiert, Sensordaten auf Lösungen der Wahrnehmungsaufgabe, insbesondere auf Objektdetektionen, abzubilden, zum Einsatz kommen.

In der closed-loop Simulation sind zeitlich-gekoppelte Fehler von besonderem Interesse. In denen in dieser Offenbarung vorgeschlagenen Verfahren wird die zeitliche Kopplung über die Sensordaten mitberücksichtigt. Dank der Fehlermodelle, die konkret den Sensorinhalt betrachten, kann durch die zeitliche Kopplung der Sensordaten auch eine Kopplung der Fehler des Wahrnehmungsmodells gut abgebildet werden.

### Kurzbeschreibung der Figuren

**Fig. 1a****-d** illustrieren schematisch ein computer-implementiertes Verfahren zum Trainieren eines Maschinenlernmodells zur Bewertung eines Verhaltens eines autonomen Systems, dafür konfiguriert eine Wahrnehmungsaufgabe, insbesondere umfassend eine Objekterkennung, zu lösen.
**Fig. 2** illustriert schematisch ein computer-implementiertes Verfahren zur Bewertung eines Verhaltens eines autonomen Systems, dafür konfiguriert eine Wahrnehmungsaufgabe, insbesondere umfassend eine Objekterkennung, zu lösen.

### Detaillierte Beschreibung

Die in dieser Offenbarung vorgeschlagenen Verfahren sind darauf gerichtet, das Verhalten des autonomen Systems insbesondere bereits zur Entwicklungszeit besser bewerten zu können. Zunächst wird ein Trainingsverfahren eines Maschinenlernmodells offenbart, anschließend ein Anwendungsverfahren des Maschinenlernmodells.

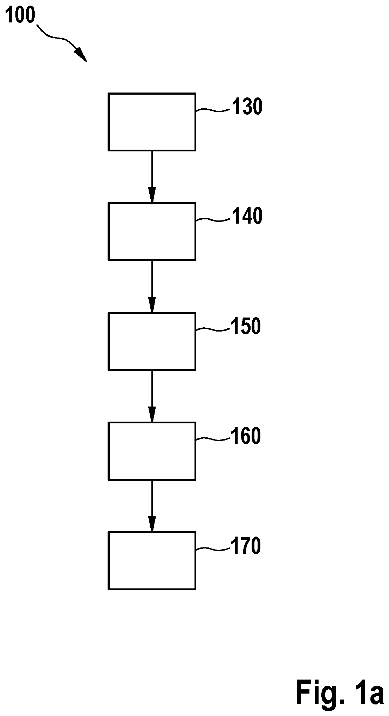

Offenbart wird zunächst ein computer-implementiertes Verfahren 100, schematisch illustriert in **Fig. 1a****,** zum Trainieren eines Maschinenlernmodells zur Bewertung eines Verhaltens eines autonomen Systems, dafür konfiguriert eine Wahrnehmungsaufgabe, zu lösen. Die Wahrnehmungsaufgabe kann insbesondere die Aufgabe einer Objekterkennung umfassen, d.h. die Wahrnehmungsaufgabe oder ein Teil davon kann zum Beispiel dadurch gelöst werden, dass ein Objekt wie z.B. ein Fußgänger erkannt wird. Alternativ kann das Verfahren 100 auf die der Bewertung des Verhaltens des autonomen Systems vorgelagerten Ermittlung einer Fehlerwahrscheinlichkeit für die Lösung der Wahrnehmungsaufgabe (insbesondere für die Objekterkennung) ausgerichtet sein.

Das Verfahren 100 umfasst Empfangen 130 von Sensordaten durch ein Wahrnehmungssystem des autonomen Systems. Das autonome System kann zum Beispiel ein ganz oder teilweise autonom fahrendes Fahrzeug sein. Alternativ oder zusätzlich kann das autonome System ein Roboter sein. Das Wahrnehmungssystem kann simulativ oder reell sein. Bei einem reellen Wahrnehmungssystem kann das Empfangen 130 der Sensordaten Messen der Sensordaten umfassen. Das Wahrnehmungssystem kann ein oder mehrere Sensorsysteme jeweils umfassend ein oder mehrere Sensoren (z.B. LIDAR, RADAR, Kamera, Schall, Ultraschall, etc.) umfassen.

Das Verfahren 100 umfasst weiterhin Empfangen 140 von Metadaten, wobei die Metadaten einen Einfluss auf eine Lösbarkeit der Wahrnehmungsaufgabe codieren. Zum Beispiel können im Falle einer Objekterkennung die Metadaten eine Erkennbarkeit des zu erkennenden Objekts codieren. Die Metadaten können zum Beispiel auf Superwissen, insbesondere auf den Simulationsteilen 110 und 120 (siehe unten), d.h. auf Simulatorwissen, basieren. Alternativ oder zusätzlich können die Metadaten zum Beispiel aus einer vorgelagerten Prozedur basierend auf Sensordaten ermittelt werden. Die Metadaten umfassen nicht notwendigerweise Informationen über die Lösbarkeit der zu lösenden Wahrnehmungsaufgabe. Vielmehr umfassen die Metadaten Faktoren, die die Lösbarkeit der Wahrnehmungsaufgabe beeinflussen. Erst im Verfahren 200 wird die Lösbarkeit in Form einer durch das Maschinenlernmodell ausgegebenen Fehlerwahrscheinlichkeit quantifiziert.

Die Metadaten können zum Beispiel einen Verdeckungsgrad eines zu erkennenden Objekts umfassen. Alternativ oder zusätzlich können die Metadaten zum Beispiel einen Helligkeitswert umfassen. Alternativ oder zusätzlich können die Metadaten zum Beispiel einen Entfernungswert des zu erkennenden Objekts umfassen. Je nach Wahrnehmungssystem und zu lösender Wahrnehmungsaufgabe können auch andere Parameter als Metadaten in Betracht kommen.

Das Verfahren 100 umfasst weiterhin Ermitteln 150 einer Fehlerwahrscheinlichkeit für die Lösung der Wahrnehmungsaufgabe, z.B. für die Objekterkennung, basierend auf den empfangenen 130 Sensordaten. Die Fehlerwahrscheinlichkeit kann als ein Maß für die Schwierigkeit (Lösbarkeit) der zu lösenden Wahrnehmungsaufgabe gesehen werden.

Das Verfahren 100 umfasst weiterhin Bereitstellen 160 (oder Empfangen) des Maschinenlernmodells, das dafür ausgelegt ist, zumindest Sensordaten und Metadaten auf zumindest eine Fehlerwahrscheinlichkeit für die Lösung der Wahrnehmungsaufgabe, insbesondere für die Objekterkennung abzubilden. Das Maschinenlernmodell kann, muss aber nicht vorab trainiert sein. Das Maschinenlernmodell kann zum Beispiel ein künstliches neuronales Netzwerk, insbesondere ein tiefes künstliches neuronales Netzwerk umfassen oder sein. Das Verfahren 100 umfasst weiterhin Trainieren 170 des Maschinenlernmodells auf Basis eines Trainingsdatensatzelements umfassend die empfangenen 130 Sensordaten, die empfangenen 140 Metadaten und die ermittelte 150 Fehlerwahrscheinlichkeit.

Anders als in **Fig. 1a** schematisch dargestellt, können die Schritte 130, 140 und 150 in jeder beliebigen Reihenfolge ausgeführt werden.

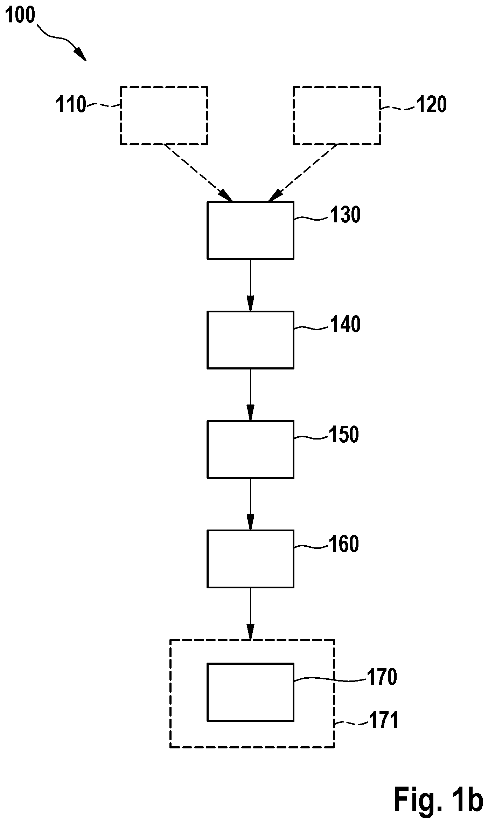

Das Verfahren 100 kann, wie in **Fig. 1b****-d** schematisch dargestellt, Simulieren 110 des Wahrnehmungssystems des autonomen Systems umfassen.

Alternativ oder zusätzlich kann das Verfahren 100, wie ebenfalls in **Fig. 1b****-d** schematisch dargestellt, Simulieren 120 einer Umgebung des Wahrnehmungssystems, insbesondere eines zu erkennenden Objekts in der Umgebung umfassen.

Die Schritte 110 und/oder 120 sind im Verfahren 100 zum Beispiel insoweit entbehrlich, als echte, d.h. gemessene Sensordaten z.B. aus Testfahrten bereits vorhanden sind. Solche gemessene Sensordaten können z.B. durch (automatisches) labeling mit Metadaten versehen werden.

Im Verfahren 100 können Sensordaten empfangen 130 werden, die ganz oder teilweise durch das Wahrnehmungssystem gemessen worden sind. Die dazugehörigen Metadaten können maschinell auf Basis der Sensordaten (z.B. via ein viertes trainiertes Maschinenlernmodell) und/oder manuell erzeugt worden sein.

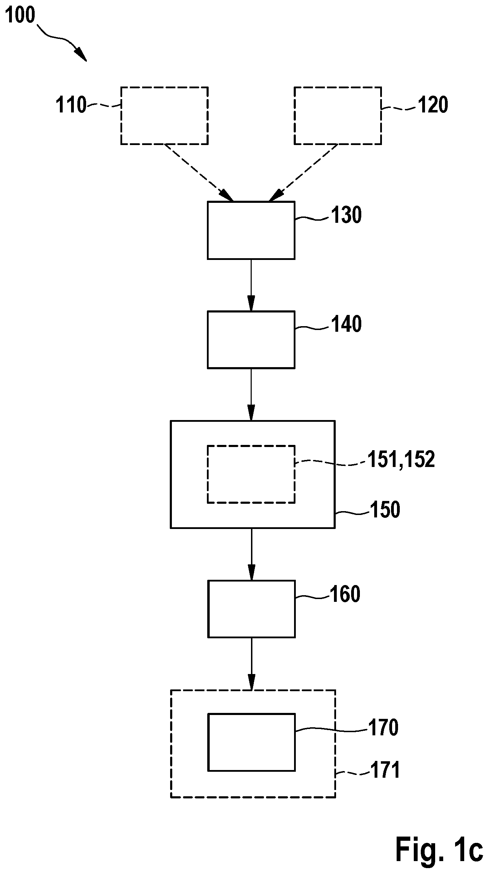

Das Ermitteln 150 der Fehlerwahrscheinlichkeit basierend auf den empfangenen 130 Sensordaten kann, wie in **Fig. 1c** schematisch illustriert, Anwenden 151 einer Vielzahl weiterer Maschinenlernmodellen umfassen, jedes dafür ausgelegt und trainiert, Sensordaten auf Lösungen der Wahrnehmungsaufgabe, insbesondere auf Objektdetektionen abzubilden, wobei je Anwenden 151 ein Wahrnehmungsergebnis, insbesondere ein Objektdetektionsergebnis, insbesondere ein Wahrnehmungserfolg oder ein Wahrnehmungsmisserfolg resultiert. Die Vielzahl der weiteren Maschinenlernmodelle kann hier durch ein weiteres Maschinenlernmodell ersetzt werden. Alternativ erweist sich aber die Vielzahl der weiteren Maschinenlernmodellen insoweit als vorteilhaft, als der Einfluss einzelner weiterer Maschinenlernmodelle auf die Fehlerwahrscheinlichkeit herausgemittelt werden. Dazu können die weiteren Maschinenlernmodelle unterschiedlich sein. Insbesondere können sie derart unterschiedlich sein, dass keine zwei der weiteren Maschinenlernmodelle identisch sind.

Das Ermitteln 150 der Fehlerwahrscheinlichkeit basierend auf den empfangenen 130 Sensordaten kann sodann, wie ebenfalls in **Fig. 1c** schematisch illustriert Ermitteln 152 der Fehlerwahrscheinlichkeit auf Basis der Wahrnehmungsergebnisse, insbesondere der Objektdetektionsergebnisse umfassen, insbesondere auf Basis der Wahrnehmungserfolge und der Wahrnehmungsmisserfolge. Zum Beispiel kann aus dem Verhältnis Anzahl der Wahrnehmungserfolge durch die Gesamtanzahl der Wahrnehmungserfolge und Wahrnehmungsmisserfolge die Fehlerwahrscheinlichkeit ermittelt werden.

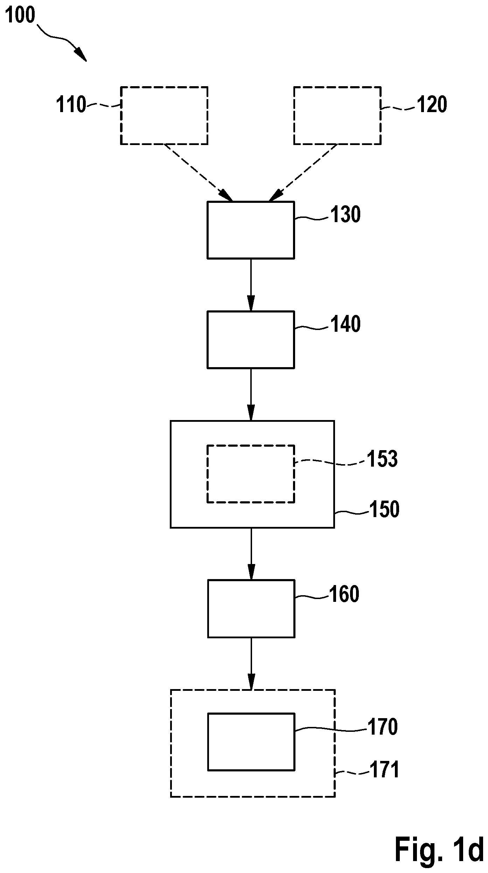

In einer anderen Ausführungsform, schematisch dargestellt in **Fig. 1d****,** kann das Ermitteln 150 der Fehlerwahrscheinlichkeit basierend auf den empfangenen 130 Sensordaten Anwenden 153 eines dritten Maschinenlernmodells umfassen, das dafür ausgelegt und trainiert ist, Sensordaten und, optional, Metadaten auf eine Fehlerwahrscheinlichkeit für die Lösung der Wahrnehmungsaufgabe abzubilden, wobei die Fehlerwahrscheinlichkeit ermittelt 150 wird.

Das Verfahren 100 kann, wie in **Fig. 1b****-d** schematisch dargestellt, Trainieren 171 des Maschinenlernmodells auf Basis eines Trainingsdatensatzes umfassen, der eine Vielzahl von Trainingsdatensatzelementen umfasst. Jedes Trainingsdatensatzelement kann nach Schritten des Verfahrens 100 erstellt worden sein. Die Vielzahl der Trainingsdatensatzelemente sollte möglichst groß sein, um ein aussagekräftiges trainiertes Maschinenlernmodell zu erhalten.

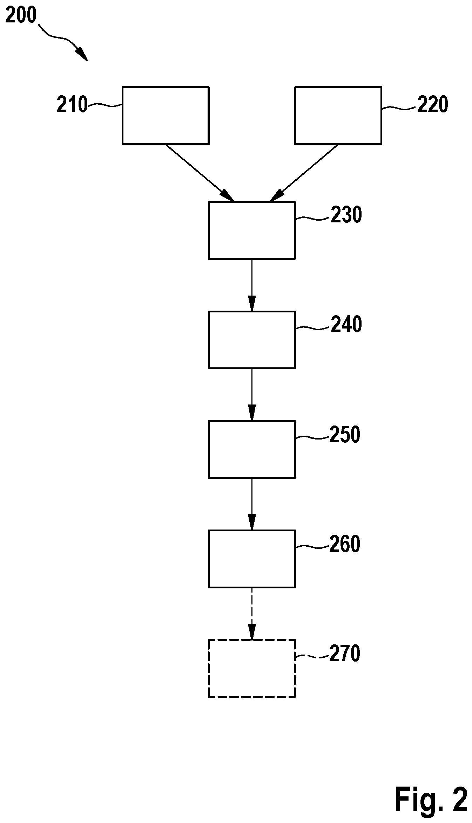

Offenbart wird weiterhin ein computer-implementiertes Verfahren 200, schematisch dargestellt in **Fig. 2****,** zur Bewertung eines Verhaltens eines autonomen Systems, dafür konfiguriert eine Wahrnehmungsaufgabe, zu lösen. Die Wahrnehmungsaufgabe kann insbesondere die Aufgabe einer Objekterkennung umfassen, d.h. die Wahrnehmungsaufgabe oder ein Teil davon kann zum Beispiel dadurch gelöst werden, dass ein Objekt wie z.B. ein Fußgänger erkannt wird.

Das Verfahren 200 umfasst Simulieren 210 eines Wahrnehmungssystems des autonomen Systems.

Das Verfahren 200 umfasst weiterhin Simulieren 220 einer Umgebung des Wahrnehmungssystems.

Dank der Simulationsschritte 210 und 220 kann das Verfahren sehr oft ausgeführt werden und eignet sich insbesondere für Monte Carlo Analysen.

Das Verfahren 200 umfasst weiterhin Bereitstellen 230 (oder Empfangen) eines Maschinenlernmodells, das darauf ausgelegt und trainiert ist, zumindest Sensordaten und Metadaten zumindest auf eine Fehlerwahrscheinlichkeit für die Lösung der Wahrnehmungsaufgabe, insbesondere für die Objekterkennung abzubilden. Wie bereits im Zusammenhang mit dem Verfahren 100 beschrieben codieren die Metadaten ebenfalls einen Einfluss auf eine Lösbarkeit der Wahrnehmungsaufgabe, insbesondere auf eine Erkennbarkeit des Objekts. Das Maschinenlernmodell kann nach dem Verfahren 100 trainiert 170, 171 worden sein.

Das Verfahren 200 umfasst weiterhin Empfangen 240 von Sensordaten und Metadaten. Die Metadaten können zum Beispiel auf Superwissen, insbesondere auf den Simulationsteilen 210 und 220, d.h. auf Simulatorwissen, basieren. Alternativ oder zusätzlich können die Metadaten zum Beispiel aus einer vorgelagerten Prozedur basierend auf Sensordaten ermittelt werden. Die Metadaten umfassen nicht notwendigerweise Informationen über die Lösbarkeit der zu lösenden Wahrnehmungsaufgabe. Vielmehr umfassen die Metadaten Faktoren, die die Lösbarkeit der Wahrnehmungsaufgabe beeinflussen. Erst im Verfahren 200 wird die Lösbarkeit in Form einer durch das Maschinenlernmodell ausgegebenen Fehlerwahrscheinlichkeit im Schritt 240 quantifiziert.

Wie bereits beschrieben können die Metadaten zum Beispiel einen Verdeckungsgrad eines zu erkennenden Objekts umfassen. Alternativ oder zusätzlich können die Metadaten zum Beispiel einen Helligkeitswert umfassen. Alternativ oder zusätzlich können die Metadaten zum Beispiel einen Entfernungswert des zu erkennenden Objekts umfassen. Je nach Wahrnehmungssystem und zu lösender Wahrnehmungsaufgabe können auch andere Parameter als Metadaten in Betracht kommen.

Das Verfahren 200 umfasst weiterhin Anwenden 250 des Maschinenlernmodells zumindest auf den empfangenen 240 Sensordaten und Metadaten, wobei zumindest eine Fehlerwahrscheinlichkeit ermittelt wird.

Das Verfahren 200 umfasst weiterhin Bewerten 260 des Verhaltens des autonomen Systems basierend auf der Fehlerwahrscheinlichkeit, wobei eine Bewertung resultiert. Das Bewerten 260 kann über einen Zeitraum erfolgen. Anders als in **Fig. 2** schematisch dargestellt, können die Schritte 230 und 240 in beliebiger Reihenfolge oder gleichzeitig erfolgen. Die Schritte 210 und 220 können, müssen aber nicht gleichzeitig erfolgen.

Das Bewerten 260 des Verhaltens des autonomen Systems kann Würfeln mindestens eines Ereignisses basierend auf der Fehlerwahrscheinlichkeit umfassen, wobei das mindestens eine Ereignis als Fehlerereignis oder Nichtfehlerereignis identifiziert wird. Das Würfeln kann zum Beispiel dadurch realisiert werden, dass eine empirische Verteilungsfunktion basierend auf der Fehlerwahrscheinlichkeit gebildet wird und deren Inverse auf einer (pseudo-)Zufallszahl auf dem reellen Interval [0, 1] ausgewertet wird.

Das Bewerten 260 des Verhaltens des autonomen Systems kann insbesondere (z.B. wie in Monte Carlo Simulationen) Würfeln einer Vielzahl von Ereignissen basierend auf der Fehlerwahrscheinlichkeit umfassen.

Das Bewerten 260 des Verhaltens des autonomen Systems kann auf mindestens zwei Ereignissen zu unterschiedlichen Zeitpunkten basieren. Das Bewerten 260 des Verhaltens des autonomen Systems kann auf einer Vielzahl von Ereignissen basieren.

Das Verfahren 200 kann Anpassen 270 des Wahrnehmungssystems des autonomen Systems basierend auf der Bewertung umfassen. Dadurch kann das Wahrnehmungssystem und/oder das autonome System verbessert werden, insbesondere die Verlässlichkeit und Sicherheit des autonomen Systems erhöht werden.

Die (genauer: das Lösen der) Wahrnehmungsaufgabe kann in beiden Verfahren 100, 200 zum Beispiel eine Objekterkennung umfassen. Alternativ oder zusätzlich kann die (genauer: das Lösen der) Wahrnehmungsaufgabe eine semantische Segmentierung umfassen. Alternativ oder zusätzlich kann die (genauer: das Lösen der) Wahrnehmungsaufgabe eine Freiraumerkennung umfassen. Weitere Wahrnehmungsaufgaben oder deren Kombinationen sind denkbar.

In beiden Verfahren 100, 200 kann das Maschinenlernmodell auf einem oder mehreren Untermodellen zusammengesetzt sein. Zum Beispiel kann das Maschinenlernmodell ein Untermodell für nahe Objekte und ein Untermodell für ferne Objekte umfassen. In diesem Fall kann zum Beispiel basierend auf den Metadaten und/oder basierend auf weiteren Eingabegrößen zunächst das jeweilige Untermodell ausgewählt werden, das trainiert 170, 171 werden soll bzw. angewandt werden soll, um die Fehlerwahrscheinlichkeit zu berechnen 250.

Offenbart wird weiterhin ein Computer-System, das dafür ausgelegt ist, das computer-implementierte Verfahren 100 zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, auszuführen. Alternativ oder zusätzlich kann das Computer-System dafür ausgelegt sein, das computer-implementierte Verfahren 200 zur Bewertung eines Verhaltens eines autonomen Systems, dafür konfiguriert eine Wahrnehmungsaufgabe, insbesondere umfassend eine Objekterkennung, zu lösen, auszuführen. Das Computer-System kann einen Prozessor und/oder einen Arbeitsspeicher umfassen.

Offenbart wird weiterhin ein Computer-Programm, das dafür ausgelegt ist, das computer-implementierte Verfahren 100 zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, auszuführen. Alternativ oder zusätzlich kann das Computer-Programm dafür ausgelegt sein, das computer-implementierte Verfahren 200 zur Bewertung eines Verhaltens eines autonomen Systems, dafür konfiguriert eine Wahrnehmungsaufgabe, insbesondere umfassend eine Objekterkennung, zu lösen, auszuführen. Das Computer-Programm kann z.B. in interpretierbarer oder in kompilierter Form vorliegen. Es kann (auch in Teilen) zur Ausführung z.B. als Bit- oder Byte-Folge in den RAM eines Computers geladen werden.

Offenbart wird weiterhin ein computer-lesbares Medium oder Signal, das das Computer-Programm speichert und/oder enthält. Das Medium kann z.B. eines von RAM, ROM, EPROM, HDD, SDD, ... umfassen, auf/in dem das Signal gespeichert wird.

## Patentansprüche

1. Computer-implementiertes Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, umfassend:
- Empfangen (130) von Sensordaten durch ein Wahrnehmungssystem des autonomen Systems;
- Empfangen (140) von Metadaten, wobei die Metadaten einen Einfluss auf eine Lösbarkeit der Wahrnehmungsaufgabe, insbesondere auf eine Erkennbarkeit des Objekts codieren;
- Ermitteln (150) einer Fehlerwahrscheinlichkeit für die Lösung der Wahrnehmungsaufgabe, z.B. für die Objekterkennung, basierend auf den empfangenen (130) Sensordaten;
- Bereitstellen (160) des Maschinenlernmodells, dafür ausgelegt, Sensordaten und Metadaten auf eine Fehlerwahrscheinlichkeit für die Lösung der Wahrnehmungsaufgabe, insbesondere für die Objekterkennung abzubilden;
- Trainieren (170) des Maschinenlernmodells auf Basis eines Trainingsdatensatzelements umfassend die empfangenen (130) Sensordaten, die empfangenen (140) Metadaten und die ermittelte (150) Fehlerwahrscheinlichkeit.

2. Verfahren (100) nach Anspruch 1, umfassend:
- Simulieren (110) des Wahrnehmungssystems des autonomen Systems;
- Simulieren (120) einer Umgebung des Wahrnehmungssystems, insbesondere eines zu erkennenden Objekts in der Umgebung.

3. Verfahren (100) nach Anspruch 1, wobei die Sensordaten durch das Wahrnehmungssystem gemessen werden; und
wobei die Metadaten maschinell auf Basis der Sensordaten und/oder manuell erzeugt worden sind.

4. Verfahren (100) nach einem der vorhergehenden Ansprüche, wobei das Ermitteln (150) der Fehlerwahrscheinlichkeit basierend auf den empfangenen (130) Sensordaten umfasst:
- Anwenden (151) einer Vielzahl weiterer Maschinenlernmodellen, jedes dafür ausgelegt und trainiert, Sensordaten auf Lösungen der Wahrnehmungsaufgabe, insbesondere auf Objektdetektionen abzubilden, wobei je Anwenden (151) ein Wahrnehmungsergebnis, insbesondere ein Objektdetektionsergebnis, insbesondere ein Wahrnehmungserfolg oder ein Wahrnehmungsmisserfolg resultiert;
- Ermitteln (152) der Fehlerwahrscheinlichkeit auf Basis der Wahrnehmungsergebnisse, insbesondere der Objektdetektionsergebnisse, insbesondere auf Basis der Wahrnehmungserfolge und der Wahrnehmungsmisserfolge;

5. Verfahren (100) nach Anspruch 4, wobei die weiteren Maschinenlernmodelle unterschiedlich sind.

6. Verfahren (100) nach einem der Ansprüche 1 bis 3, wobei das Ermitteln (150) der Fehlerwahrscheinlichkeit basierend auf den empfangenen (130) Sensordaten umfasst:
- Anwenden (153) eines dritten Maschinenlernmodells, dafür ausgelegt und trainiert, Sensordaten und, optional, Metadaten auf eine Fehlerwahrscheinlichkeit für die Lösung der Wahrnehmungsaufgabe abzubilden, wobei die Fehlerwahrscheinlichkeit ermittelt (150) wird.

7. Verfahren (100) nach einem der vorhergehenden Ansprüche, umfassend:
- Trainieren (171) des Maschinenlernmodells auf Basis eines Trainingsdatensatzes umfassend eine Vielzahl von Trainingsdatensatzelementen.

8. Computer-implementiertes Verfahren (200) zur Bewertung eines Verhaltens eines autonomen Systems, dafür konfiguriert eine Wahrnehmungsaufgabe, insbesondere umfassend eine Objekterkennung, zu lösen; umfassend:
- Simulieren (210) eines Wahrnehmungssystems des autonomen Systems;
- Simulieren (220) einer Umgebung des Wahrnehmungssystems;
- Bereitstellen (230) eines Maschinenlernmodells, darauf ausgelegt und trainiert, Sensordaten und Metadaten auf eine Fehlerwahrscheinlichkeit für die Lösung der Wahrnehmungsaufgabe, insbesondere für die Objekterkennung abzubilden, wobei die Metadaten einen Einfluss auf eine Lösbarkeit der Wahrnehmungsaufgabe, insbesondere auf eine Erkennbarkeit des Objekts codieren;
- Empfangen (240) von Sensordaten und Metadaten;
- Anwenden (250) des Maschinenlernmodells auf den empfangenen (240) Sensordaten und Metadaten, wobei eine Fehlerwahrscheinlichkeit ermittelt wird;
- Bewerten (260) des Verhaltens des autonomen Systems basierend auf der Fehlerwahrscheinlichkeit, wobei eine Bewertung resultiert.

9. Verfahren (200) nach Anspruch 8, wobei das Bewerten (260) des Verhaltens des autonomen Systems Würfeln mindestens eines Ereignisses basierend auf der Fehlerwahrscheinlichkeit umfasst, wobei das mindestens eine Ereignis als Fehlerereignis oder Nichtfehlerereignis identifiziert wird.

10. Verfahren (200) nach Anspruch 9, wobei das Bewerten (260) des Verhaltens des autonomen Systems auf mindestens zwei Ereignissen zu unterschiedlichen Zeitpunkten basiert.

11. Verfahren (200) nach Anspruch 10, wobei das Bewerten (260) des Verhaltens des autonomen Systems auf einer Vielzahl von Ereignissen basiert.

12. Verfahren (200) nach einem der Ansprüche 8 bis 11, umfassend:
- Anpassen (270) des Wahrnehmungssystems des autonomen Systems basierend auf der Bewertung.

13. Verfahren (200) nach einem der Ansprüche 8 bis 12, wobei das Maschinenlernmodell nach dem Verfahren (100) aus einem der Ansprüche 1 bis 7 trainiert (170, 171) worden ist.

14. Verfahren (100, 200) nach einem der vorhergehenden Ansprüche, wobei die Metadaten einen Verdeckungsgrad eines zu erkennenden Objekts, einen Helligkeitswert und/oder einen Entfernungswert des zu erkennenden Objekts umfassen.

15. Verfahren (100, 200) nach einem der vorhergehenden Ansprüche, wobei die Wahrnehmungsaufgabe eine Objekterkennung, eine semantische Segmentierung und/oder eine Freiraumerkennung umfasst.

16. Computer-System, dafür ausgelegt:
- das computer-implementierte Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, nach einem der Ansprüche 1 bis 7 oder 14 bis 15; und/oder
- das computer-implementierte Verfahren (200) zur Bewertung eines Verhaltens eines autonomen Systems, dafür konfiguriert eine Wahrnehmungsaufgabe, insbesondere umfassend eine Objekterkennung, zu lösen, nach einem der Ansprüche 8 bis 15;
auszuführen.

17. Computer-Programm, dafür ausgelegt:
- das computer-implementierte Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, nach einem der Ansprüche 1 bis 7 oder 14 bis 15; und/oder
- das computer-implementierte Verfahren (200) zur Bewertung eines Verhaltens eines autonomen Systems, dafür konfiguriert eine Wahrnehmungsaufgabe, insbesondere umfassend eine Objekterkennung, zu lösen, nach einem der Ansprüche 8 bis 15;
auszuführen.

18. Computer-lesbares Medium oder Signal, das das Computer-Programm nach Anspruch 17 speichert und/oder enthält.

## Geänderte Patentansprüche

### Geänderte Patentansprüche gemäss Regel 137(2) EPÜ.

1. Computer-implementiertes Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, umfassend:
- Empfangen (130) von Sensordaten durch ein Wahrnehmungssystem des autonomen Systems;
- Empfangen (140) von Metadaten, wobei die Metadaten einen Einfluss auf eine Lösbarkeit der Wahrnehmungsaufgabe, insbesondere auf eine Erkennbarkeit des Objekts codieren;
- Ermitteln (150) einer Fehlerwahrscheinlichkeit für die Lösung der Wahrnehmungsaufgabe, z.B. für die Objekterkennung, basierend auf den empfangenen (130) Sensordaten;
- Bereitstellen (160) des Maschinenlernmodells, dafür ausgelegt, Sensordaten und Metadaten auf eine Fehlerwahrscheinlichkeit für die Lösung der Wahrnehmungsaufgabe, insbesondere für die Objekterkennung abzubilden;
- Trainieren (170) des Maschinenlernmodells auf Basis eines Trainingsdatensatzelements umfassend die empfangenen (130) Sensordaten, die empfangenen (140) Metadaten und die ermittelte (150) Fehlerwahrscheinlichkeit.

2. Verfahren (100) nach Anspruch 1, umfassend:
- Simulieren (110) des Wahrnehmungssystems des autonomen Systems;
- Simulieren (120) einer Umgebung des Wahrnehmungssystems, insbesondere eines zu erkennenden Objekts in der Umgebung.

3. Verfahren (100) nach Anspruch 1, wobei die Sensordaten durch das Wahrnehmungssystem gemessen werden; und
wobei die Metadaten maschinell auf Basis der Sensordaten und/oder manuell erzeugt worden sind.

4. Verfahren (100) nach einem der vorhergehenden Ansprüche, wobei das Ermitteln (150) der Fehlerwahrscheinlichkeit basierend auf den empfangenen (130) Sensordaten umfasst:
- Anwenden (151) einer Vielzahl weiterer Maschinenlernmodellen, jedes dafür ausgelegt und trainiert, Sensordaten auf Lösungen der Wahrnehmungsaufgabe, insbesondere auf Objektdetektionen abzubilden, wobei je Anwenden (151) ein Wahrnehmungsergebnis, insbesondere ein Objektdetektionsergebnis, insbesondere ein Wahrnehmungserfolg oder ein Wahrnehmungsmisserfolg resultiert;
- Ermitteln (152) der Fehlerwahrscheinlichkeit auf Basis der Wahrnehmungsergebnisse, insbesondere der Objektdetektionsergebnisse, insbesondere auf Basis der Wahrnehmungserfolge und der Wahrnehmungsmisserfolge;

5. Verfahren (100) nach Anspruch 4, wobei die weiteren Maschinenlernmodelle unterschiedlich sind.

6. Verfahren (100) nach einem der vorhergehenden Ansprüche, umfassend:
- Trainieren (171) des Maschinenlernmodells auf Basis eines Trainingsdatensatzes umfassend eine Vielzahl von Trainingsdatensatzelementen.

7. Computer-implementiertes Verfahren (200) zur Bewertung eines Verhaltens eines autonomen Systems, dafür konfiguriert eine Wahrnehmungsaufgabe, insbesondere umfassend eine Objekterkennung, zu lösen; umfassend:
- Simulieren (210) eines Wahrnehmungssystems des autonomen Systems;
- Simulieren (220) einer Umgebung des Wahrnehmungssystems;
- Bereitstellen (230) eines Maschinenlernmodells, darauf ausgelegt und trainiert, Sensordaten und Metadaten auf eine Fehlerwahrscheinlichkeit für die Lösung der Wahrnehmungsaufgabe, insbesondere für die Objekterkennung abzubilden, wobei die Metadaten einen Einfluss auf eine Lösbarkeit der Wahrnehmungsaufgabe, insbesondere auf eine Erkennbarkeit des Objekts codieren;
- Empfangen (240) von Sensordaten durch das Wahrnehmungssystem ***[S. 3, Z. 34-36; S. 4, Z. 5-6; S. 6, Z. 7-8]*** und Metadaten;
- Anwenden (250) des Maschinenlernmodells auf den empfangenen (240) Sensordaten und Metadaten, wobei eine Fehlerwahrscheinlichkeit ermittelt wird;
- Bewerten (260) des Verhaltens des autonomen Systems basierend auf der Fehlerwahrscheinlichkeit, wobei eine Bewertung resultiert.

8. Verfahren (200) nach Anspruch 7, wobei das Bewerten (260) des Verhaltens des autonomen Systems Würfeln mindestens eines Ereignisses basierend auf der Fehlerwahrscheinlichkeit umfasst, wobei das mindestens eine Ereignis als Fehlerereignis oder Nichtfehlerereignis identifiziert wird.

9. Verfahren (200) nach Anspruch 8, wobei das Bewerten (260) des Verhaltens des autonomen Systems auf mindestens zwei Ereignissen zu unterschiedlichen Zeitpunkten basiert.

10. Verfahren (200) nach Anspruch 9, wobei das Bewerten (260) des Verhaltens des autonomen Systems auf einer Vielzahl von Ereignissen basiert.

11. Verfahren (200) nach einem der Ansprüche 7 bis 10, umfassend:
- Anpassen (270) des Wahrnehmungssystems des autonomen Systems basierend auf der Bewertung.

12. Verfahren (200) nach einem der Ansprüche 7 bis 11, wobei das Maschinenlernmodell nach dem Verfahren (100) aus einem der Ansprüche 1 bis 6 trainiert (170, 171) worden ist.

13. Verfahren (100, 200) nach einem der vorhergehenden Ansprüche, wobei die Metadaten einen Verdeckungsgrad eines zu erkennenden Objekts, einen Helligkeitswert und/oder einen Entfernungswert des zu erkennenden Objekts umfassen.

14. Verfahren (100, 200) nach einem der vorhergehenden Ansprüche, wobei die Wahrnehmungsaufgabe eine Objekterkennung, eine semantische Segmentierung und/oder eine Freiraumerkennung umfasst.

15. Computer-System, dafür ausgelegt:
- das computer-implementierte Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, nach einem der Ansprüche 1 bis 6 oder 13 bis 14; und/oder
- das computer-implementierte Verfahren (200) zur Bewertung eines Verhaltens eines autonomen Systems, dafür konfiguriert eine Wahrnehmungsaufgabe, insbesondere umfassend eine Objekterkennung, zu lösen, nach einem der Ansprüche 7 bis 14;
auszuführen.

16. Computer-Programm, dafür ausgelegt:
- das computer-implementierte Verfahren (100) zum Trainieren eines Maschinenlernmodells zur Bewertung eines Verhaltens eines autonomen Systems, dafür konfiguriert, eine Wahrnehmungsaufgabe, insbesondere umfassend eine Objekterkennung, zu lösen, nach einem der Ansprüche 1 bis 6 oder 13 bis 14; und/oder
- das computer-implementierte Verfahren (200) zur Bewertung eines Verhaltens eines autonomen Systems, dafür konfiguriert eine Wahrnehmungsaufgabe, insbesondere umfassend eine Objekterkennung, zu lösen, nach einem der Ansprüche 7 bis 14;
auszuführen.

17. Computer-lesbares Medium oder Signal, das das Computer-Programm nach Anspruch 16 speichert und/oder enthält.
